(19) Europäisches Patentamt
European Patent Office
Office européen des brevets

(11) **EP 3 680 101 B1**

(12) **EUROPÄISCHE PATENTSCHRIFT**

(45) Veröffentlichungstag und Bekanntmachung des Hinweises auf die Patenterteilung:
**02.03.2022 Patentblatt 2022/09**

(21) Anmeldenummer: **19151346.4**

(22) Anmeldetag: **11.01.2019**

(51) Internationale Patentklassifikation (IPC):
**B32B 15/01** (2006.01)    **B32B 15/20** (2006.01)
**B32B 38/00** (2006.01)    **H01L 23/00** (2006.01)
**C22C 9/00** (2006.01)    **B32B 7/05** (2019.01)
**G01R 3/00** (2006.01)

(52) Gemeinsame Patentklassifikation (CPC):
**B32B 15/01; B32B 15/20; B32B 38/0004; B32B 38/0012; H01L 24/42; H01L 24/43; H01L 24/45;** B32B 7/05; C22C 9/00; G01R 3/00; H01L 2224/45014; H01L 2224/4503

(54) **GESCHICHTETE CU/REFRAKTÄRMETALL-FOLIE UND VERFAHREN ZU DEREN HERSTELLUNG**

LAYERED CU/REFRACTORY METAL FILM AND METHOD FOR PRODUCING THE SAME

FEUILLE DE MÉTAL RÉFRACTAIRE / CUIVRE DURCIE ET SON PROCÉDÉ DE FABRICATION

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**15.07.2020 Patentblatt 2020/29**

(73) Patentinhaber: **Heraeus Deutschland GmbH & Co. KG**
**63450 Hanau (DE)**

(72) Erfinder: **FECHER, Jonas**
**63450 Hanau (DE)**

(74) Vertreter: **Schultheiss & Sterzel Patentanwälte PartG mbB**
**Berner Straße 52**
**60437 Frankfurt am Main (DE)**

(56) Entgegenhaltungen:
• JOHN S. CARPENTER ET AL: "Processing Parameter Influence on Texture and Microstructural Evolution in Cu-Nb Multilayer Composites Fabricated via Accumulative Roll Bonding", METALLURGICAL AND MATERIALS TRANSACTIONS A: PHYSICAL METALLURGY & MATERIALS SCIENCE., Bd. 45, Nr. 4, 10. Januar 2014 (2014-01-10), Seiten 2192-2208, XP055593776, US ISSN: 1073-5623, DOI: 10.1007/s11661-013-2162-4

• MARA ET AL: "Tensile behavior of 40nm Cu/Nb nanoscale multilayers", SCRIPTA MATERIALIA, ELSEVIER, AMSTERDAM, NL, Bd. 58, Nr. 10, 11. Januar 2008 (2008-01-11), Seiten 874-877, XP022527526, ISSN: 1359-6462, DOI: 10.1016/J.SCRIPTAMAT.2008.01.005

• LIM S C V ET AL: "Length scale effects on recrystallization and texture evolution in Cu layers of a roll-bonded Cu-Nb composite", MATERIALS SCIENCE AND ENGINEERING: A, ELSEVIER, AMSTERDAM, NL, Bd. 520, Nr. 1-2, 15. September 2009 (2009-09-15), Seiten 189-196, XP026350114, ISSN: 0921-5093 [gefunden am 2009-05-22]

• S.C JHA ET AL: "High-strength high-conductivity Cu-Nb microcomposite sheet fabricated via multiple roll bonding", METALLURGICAL TRANSACTIONS A- PHYSICAL METALLURGY AND MATERIALS SCIENCE, Bd. 24:1, 2. Januar 1993 (1993-01-02), Seiten 15-20, XP055594121, US ISSN: 0360-2133, DOI: 10.1007/BF02669597

• Bsi: "British Standard Specification for Copper for Electrical Purposes", , 31. Dezember 1985 (1985-12-31), XP055594198, Gefunden im Internet: URL:https://allcivilstandard.com/wp-content/uploads/2019/02/BS-01434-1985-scan.pdf [gefunden am 2019-06-05]

EP 3 680 101 B1

- PANTSYRNY V I ET AL: "High Strength, High Conductivity Microcomposite Cu-Nb Wires with Cross Sections in the Range of 0.01-100", IEEE TRANSACTIONS ON APPLIED SUPERCONDUCTIVITY, IEEE SERVICE CENTER, LOS ALAMITOS, CA, US, Bd. 17, Nr. 2, 1. Juni 2008 (2008-06-01), Seiten 616-619, XP011214737, ISSN: 1051-8223

**Beschreibung**

Die Erfindung betrifft eine Prüfnadel zur Messung einer elektrischen Kontaktierung und einen Bonddraht zur elektrischen Kontaktierung eines Chips, wobei die Prüfnadel oder der Bonddraht eine Folie zur Herstellung von Prüfnadeln oder Bonddrähten aufweist sowie ein Verfahren zur Herstellung einer solchen Prüfnadel oder eines solchen Bonddrahts.

Prüfnadeln werden bei der Herstellung von Leistungselektronik, der Kontaktierung von Chips und anderen elektrischen Schaltungen zur Prüfung der Qualität von elektrischen Kontaktierungen eingesetzt (siehe hierzu beispielsweise die US 2014/0266278 A1 und die US 2010/0194415 A1). Aktuell werden für sogenannte "Probe Needles" (Prüfnadeln) Metalle oder Legierungen verwendet, die eine hohe elektrische und thermische Leitfähigkeit aber auch hohe Härten und Zugfestigkeiten besitzen. Dabei dient die elektrische Leitfähigkeit von reinem Kuper (100% IACS) als Referenz. Kupfer (Cu) kann zu diesen Zwecken jedoch nicht eingesetzt werden da es deutlich zu duktil ist und sich die Nadel beim Einsatz verformen würde. Typische Materialien für Prüfnadeln sind alterungsgehärtete Palladium-Silber-Legierungen, die 10% Gold und 10% Platin enthalten und beispielsweise unter den Produktnamen Paliney® 7 und Hera 648 vertrieben werden. Als Materialien für Folien zur Herstellung von Prüfnadeln werden aber auch PtNi-Legierungen oder Rhodium verwendet. Bei solchen Metallen oder Legierungen die einen möglichst guten Kompromiss zwischen elektrischer Leitfähigkeit, thermischer Leitfähigkeit, Zugfestigkeit sowie Härte darstellen, beträgt die maximal mögliche elektrische Leitfähigkeit 5-30% IACS.

Neben Prüfnadeln profitieren aber auch andere Anwendungen, wie insbesondere Bonddrähte, von Materialien mit hohen elektrischen und thermischen Leitfähigkeiten und gleichzeitig guten mechanische Eigenschaften, wie einer hohen Härte und Zugfestigkeit.

Anwendungen wie Prüfnadeln (Probe Needles) oder Bondbänder (Bonddrähte) in der Leistungselektronik erfordern neben einer hohen elektrischen Leitfähigkeit auch eine hohe mechanische Festigkeit und Härte. Dabei ist auch die Temperaturbeständigkeit beziehungsweise die Warmfestigkeit von entscheidender Bedeutung. Hierzu werden derzeit ausscheidungsgehärtete Kupfer-Legierungen (Cu-Legierungen) verwendet, welche durch Kokillenguss, Lösungsglühen, Ausscheidungswärmebehandlung und Walzen zu dünnen Bändern mit einer Dicke von weniger als 54 μm verarbeitet werden.

Durch die Ausscheidungshärtung sind ausscheidungsgehärtete Cu-Legierungen, insbesondere durch die in der Anwendung auftretende mechanische Belastung nur bedingt warmfest. Das heißt, dass sie bei erhöhter Temperatur erweichen und ihre Funktion nicht mehr erfüllen können. Insbesondere bei sehr dünnen Prüfnadeln kann es durch die dadurch auftretenden hohen Stromstärkedichten bei gleichzeitig geringem Querschnitt zur Wärmeableitung zu einer erheblichen Erwärmung der Prüfnadeln im Einsatz kommen. Auch bei den erwärmten Prüfnadeln darf es nicht zu einer Veränderung während der Messung und der elektrischen Kontaktierung durch die Prüfnadeln aufgrund von zu starken Änderungen der elektrischen und mechanischen Eigenschaften der Prüfnadeln kommen. Deshalb werden derzeit insbesondere für dünne Prüfnadeln warmfestere, vorzugsweise mischkristallhärtende Legierungen wie zum Beispiel aus Cu und Be verwendet, die aber eine wesentlich schlechtere elektrische Leitfähigkeit aufweisen als ausscheidungsgehärtete Cu-Legierungen.

Die WO 2016/009293 A1 schlägt eine Prüfnadel vor, bei der eine Prüfnadel an deren Spitze aus einem mechanisch harten ersten Material besteht und dessen Rest aus einem zweiten Material mit einer hohen elektrischen Leitfähigkeit besteht. Ähnliche Prüfnadeln sind auch aus der US 2013/0099813 A1, der EP 2 060 921 A1 und der US 2012/0286816 A1 bekannt. Nachteilig ist hieran, dass die Prüfnadel über ihre Länge keine homogenen physikalischen Eigenschaften mehr hat und dass die elektrische und thermische Leitfähigkeit aber auch die Zugfestigkeit sehr stark von der Verbindung zwischen den beiden Materialien abhängt. Zudem lässt sich eine niedrige elektrische Leitfähigkeit in einem Bereich nicht einfach durch eine hohe elektrische Leitfähigkeit in einem anderen Bereich ausgleichen, da der Strom beide Bereiche passieren muss.

Der Artikel "Processing and Deformation Behavior of Bulk Cu-Nb Nanolaminates" von T. Nizolek, N.A. Mara, I.J. Beyerlein, J.T. Avallone, J.E. Scott und T.M. Pollock in Metallogr. Microstruct. Anal. (2014) 3, 470-476 schlägt ein einen massiven Körper aus gleichen Anteilen von Kupfer und Niob vor, der durch mehrfaches Walzen und Falten eines Kupfer-Blechs mit einem Niob-Blech gewonnen wird. Der so gefertigte Körper hat eine große mechanische Härte und Zähigkeit. Ein solches Material wird auch in I.J. Beyerlein et al.: "Interface-driven microstructure development and ultra high strength of bulk nanostructured Cu-Nb multilayers" J. Mater. Res., Vol. 28, No. 13, Jul 14, 2013 beschrieben und bezüglich der mechanischen Eigenschaften untersucht. In den Veröffentlichungen werden die starken mechanischen Eigenschaften thematisiert. Die elektrischen Eigenschaften dieses Materials sind dagegen nicht thematisiert. Aufgrund einer unklaren elektrischen Leitfähigkeit des Materials kann dieses nicht ohne weiteres zur Herstellung vom Prüfnadeln eingesetzt werden. Es wäre zudem äußerst aufwendig, aus einem derartigen Material die dünnen Prüfnadeln oder Bonddrähte herzustellen. Ferner wären gegebenenfalls die relevanten physikalischen Eigenschaften aufgrund der inhomogenen Schichtstruktur auch abhängig davon, in welcher Orientierung man die Prüfnadeln oder Bonddrähte aus dem Material schneidet. Der Artikel "Processing Parameter Influence on Texture and Microstructural Evolution in Cu-Nb Multilayer Composites Fabricated via Accumulative Roll Bonding" von J.S. Carpenter, R.J. McCabe, S.J.

Zheng, T.A. Wynn, N.A. Mara und I.J. Beyerlein in Metallurgical and Materials Transactions A (April 2014), Vol. 45A, 2192-2208 beschreibt einen Prozess eines Walzens und Faltens einer 50/50 CuNb-Legierung. Eine andere Zusammensetzung wird in dem Artikel "High-Strength High-Conductivity Cu-Nb Microcomposite Sheet Fabricated via Multiple Roll Bonding" von S.C. Jha, R.G. Delagi, J.A. Forster und P.D. Krotz in Metallurgical and Materials Transactions A (Januar 1993), Vol. 24A, 15-20 untersucht, wobei dort die Herstellung von Drähten durch Bündeln und Ziehen aus einer nicht laminierten Gusslegierung vorgeschlagen wird. Derartig hergestellte Drähte haben keine hohe elektrische Leitfähigkeit bei gleichzeitig guten mechanischen Eigenschaften, wie einer hohen Härte, Warmfestigkeit und Zugfestigkeit. In dem Artikel "Length sacle effects on recrystallization and texture evolution in Cu layers of a roll-bonded Cu-Nb composite" von S.C.V. Lim und A.D. Rollett in Materials Science and Engeneering A 520 (2009) 189-195 wird die Rekristallisation von reinem Kupfer und legiertem Kupfer in dünnen Schichten anhand der Textur untersucht. In dem Artikel "Tensile behavior of 40 nm Cu/Nb nanoscale multilayers" von N.A. Mara, D. Bhattacharyya, R.G. Hoagland und A. Misra in Science Direct, Scripta Materialia 58 (2008) 874-877 wird das Streckverhalten von Kupfer-Niob-Schichtverbunden untersucht. Der Artikel "High-Strength, High-Conductivity Microcomposite Cu-Nb Wires with Cross Sections in the Range of 0.01 - 100 mm2" von V.I. Pantsyrny et al. in IEEE Transactions on Applied Superconductivity (Juni 2008), Vol. 18, No. 2, 616-619 offenbart einen Draht aus einem Cu-Nb-Nonokomposit, das durch Herstellen aus der Schmelze und durch Ziehen eines Drahts hergestellt ist.

Die Aufgabe der Erfindung besteht also darin, die Nachteile des Stands der Technik zu überwinden. Insbesondere sollen eine Prüfnadel beziehungsweise ein Bonddraht gefunden werden und ein Verfahren zur Herstellung einer Prüfnadel oder eines Bonddrahts gefunden werden, wobei die Prüfnadeln oder der Bonddraht eine hohe elektrische Leitfähigkeit bei gleichzeitig guten mechanischen Eigenschaften, wie einer hohen Härte, Warmfestigkeit und Zugfestigkeit auf einfach Weise aufweisen.

Die Prüfnadeln oder Bonddrähte können aus einer Folie hergestellt werden. Beschichtungsverfahren sind zur Herstellung solcher Folien ungeeignet, da sich die Beschichtungen nicht ohne weiteres vom Substrat lösen lassen und die physikalischen Eigenschaften eines beschichteten Substrats nicht denen der Beschichtung entsprechen. Gleichzeitig ist es sehr aufwendig, Beschichtungen mit der notwendigen Dicke zu erzeugen.

Die Aufgaben der Erfindung werden gelöst durch eine Prüfnadel zur Messung einer elektrischen Kontaktierung und durch einen Bonddraht zur elektrischen Kontaktierung eines Chips, wobei die Prüfnadel oder der Bonddraht eine Folie zur Herstellung von Prüfnadeln oder Bonddrähten aufweist, die Folie aufweisend eine Dicke von maximal 100 μm und die Folie aufweisend einen Schichtverbund aus

    Cu-Schichten aus Kupfer und/oder einer Kupfer-Basis-Legierung mit zumindest 90 Gew% Kupfer und Refraktärmetall-Schichten aus einem Refraktärmetall der Gruppe Niob und Tantal oder Refraktärmetall-Schichten aus einer Refraktärmetall-Basis-Legierung mit zumindest 90 Gew% zumindest eines Refraktärmetalls aus der Gruppe Niob, Tantal, Vanadium, Wolfram, Molybdän und Chrom, wobei der Schichtverbund zumindest 125 Cu-Schichten und 125 Refraktärmetall-Schichten pro 10 μm Dicke aufweist, wobei die Prüfnadel eine Dicke zwischen 2 μm und 100 μm aufweist oder wobei der Bonddraht einen Querschnitt zwischen 2 μm und 100 μm aufweist.

Niob und Tantal werden jedoch besonders bevorzugt, wobei Niob gegenüber Tantal bevorzugt wird. Als Refraktärmetall-Basis-Legierung werden, dementsprechend Nb-Basis-Legierungen mit zumindest 90 Gew% Niob, Ta-Basis-Legierungen mit zumindest 90 Gew% Tantal und NbTa-Basis-Legierungen mit zumindest 90 Gew% NbTa bevorzugt.

Die zu der Folie aber auch zu dem erfindungsgemäßen Verfahren angegebenen Metalle Kupfer (Cu), Niob (Nb), Tantal (Ta), Vanadium (V), Molybdän (Mo) und Wolfram (W) können auf übliche Weise dargestellt werden. Es kann sein, dass das Cu sowie das Nb, das Ta, das V, das Mo und/oder das W sich einschließlich üblicher Verunreinigungen verstehen, insbesondere einschließlich erschmelzungsbedingter Verunreinigungen. Derartige Verunreinigungen ergeben sich aus dem Herstellungsprozess und liegen üblicherweise bei einem Anteil von höchstens 1 Gew% oder weniger, vorzugsweise bei einem Anteil von höchstens 0,1 Gew% oder weniger.

Als Cu-Schicht kann Cu einschließlich erschmelzungsbedingter Verunreinigungen oder eine Cu-Basis-Legierung mit zumindest 90 Gew% Cu einschließlich erschmelzungsbedingter Verunreinigungen verwendet werden.

Als Refraktärmetall-Schichten können Nb-Schichten aus Nb einschließlich erschmelzungsbedingter Verunreinigungen oder aus einer Nb-Basis-Legierung mit zumindest 90 Gew% Nb einschließlich erschmelzungsbedingter Verunreinigungen verwendet werden.

Als Refraktärmetall-Schichten können Ta-Schichten aus Ta einschließlich erschmelzungsbedingter Verunreinigungen oder aus einer Ta-Basis-Legierung mit zumindest 90 Gew% Ta einschließlich erschmelzungsbedingter Verunreinigungen verwendet werden.

Als Refraktärmetall-Schichten können auch NbTa-Legierungen mit zumindest 90 Gew% NbTa einschließlich erschmelzungsbedingter Verunreinigungen verwendet werden.

Es kann bevorzugt vorgesehen sein, dass das Kupfer oder die Kupfer-Basis-Legierung weniger als 20 ppm (parts per million) Schwefel, weniger als 10 ppm Eisen und weniger als 10 ppm Nickel enthält.

Es kann bevorzugt auch vorgesehen sein, dass das Refraktärmetall oder die Refraktärmetall-Basis-Legierung weniger als 50 ppm Eisen, weniger als 50 ppm Nickel enthält und jeweils weniger als 10 ppm von chemischen Elementen enthält, die keine Refraktärmetalle sind.

Es kann bevorzugt auch vorgesehen sein, dass das Niob oder die Niob-Basis-Legierung weniger als 50 ppm Kohlenstoff, weniger als 50 ppm Sauerstoff, weniger als 50 ppm Stickstoff, weniger als 50 ppm Eisen, weniger als 50 ppm Nickel und bis zu 200 ppm Tantal enthält.

Es kann bevorzugt auch vorgesehen sein, dass das Tantal oder die Tantal-Basis-Legierung weniger als 50 ppm Kohlenstoff, weniger als 50 ppm Sauerstoff, weniger als 50 ppm Stickstoff, weniger als 50 ppm Eisen, weniger als 50 ppm Nickel und bis zu 200 ppm Niob enthält.

Es kann bevorzugt ferner vorgesehen sein, dass die Tantal-Niob-Legierung weniger als 50 ppm Kohlenstoff, weniger als 50 ppm Sauerstoff, weniger als 50 ppm Stickstoff, weniger als 50 ppm Eisen und weniger als 50 ppm Nickel enthält.

Weitere Verunreinigungen außer den hier angegebenen können unterhalb von 5 ppm liegen, vorzugsweise unterhalb von 1 ppm.

Die Cu-Schichten sowie die Refraktärmetall-Schichten liegen vorzugsweise schichtförmig in einer Ebene senkrecht zur Dicke der Folie vor (also parallel zur Folienebene).

Bei erfindungsgemäßen Verfahren sind die Cu-Schichten und die Refraktärmetall-Schichten miteinander kaltverschweißt.

Prüfnadeln dienen dazu, das Vorhandensein einer elektrischen Kontaktierung durch Messung der elektrischen Leitfähigkeit zu bestimmen. Prüfnadeln werden auch als "probe-needles" bezeichnet und sind dem Fachmann unter diesem Fachbegriff bekannt.

Bonddrähte, die auch als Bondbändchen bezeichnet werden können, dienen der elektrischen Kontaktierung von Chips mit integrierten Schaltungen.

Die Refraktärmetall-Schichten können nicht durchgehend sein und können auch räumlich begrenzte Inseln innerhalb der Folie bilden. Auch die Cu-Schichten können Löcher und Bereiche mit Durchbrechungen aufweisen. Es wird jedoch erfindungsgemäß bevorzugt, wenn die Refraktärmetall-Schichten und auch die Cu-Schichten durchgehend sind.

Unter einer Schicht (Cu-Schicht, Refraktärmetall-Schicht, Nb-Schicht, Ta-Schicht, NbTa-Schicht) wird im Sinne der vorliegenden Patentanmeldung aber nicht nur eine durchgehende Fläche verstanden, sondern auch eine mit Durchbrechungen und im Falle der Refraktärmetall-Schichten auch eine in Form von mehreren lokalen flachen Einschlüssen vorliegende Schicht. Die flachen Einschlüsse können dabei bezogen auf eine Richtung parallel zur Dicke der Folie flach sein.

Bevorzugt kann vorgesehen sein, dass die Folie eine Dicke von maximal 50 μm aufweist. Bei einer Folie mit dieser Dicke können dünne Prüfnadeln und Bonddrähte direkt aus der Folie geschnitten oder gestanzt werden.

Es kann bevorzugt vorgesehen sein, dass die Folie zumindest 150 Cu-Schichten und 150 Refraktärmetall-Schichten pro 10 μm Dicke aufweist, besonders bevorzugt zumindest 200 Cu-Schichten und 200 Refraktärmetall-Schichten pro 10 μm Dicke aufweist, ganz besonders bevorzugt zumindest 500 Cu-Schichten und 500 Refraktärmetall-Schichten pro 10 μm Dicke aufweist. Bei diesen Dicken ergibt sich jeweils eine weitere Verbesserung der mechanischen Eigenschaften der Folie, ohne dass die gewünschte elektrische Leitfähigkeit darunter leidet.

Bevorzugt kann vorgesehen sein, dass die Folie aus dem Schichtverbund besteht. Die Folie hat dann keine weiteren Bestandteile außer den Cu-Schichten und den Refraktärmetall-Schichten.

Die Folie ist bevorzugt eine Metallfolie. Die Folie kann auch eine beschichtete Metallfolie sein.

Bei erfindungsgemäßen Folien kann vorgesehen sein, dass die Refraktärmetall-Schichten Nb-Schichten sind, die aus Niob oder einer Nb-Basis-Legierung mit zumindest 90 Gew% Niob bestehen, oder die Refraktärmetall-Schichten Ta-Schichten sind, die aus Tantal oder einer Ta-Basis-Legierung mit zumindest 90 Gew% Tantal bestehen, oder die Refraktärmetall-Schichten NbTa-Schichten sind, die aus einer NbTa-Legierung mit zumindest 90 Gew% NbTa bestehen.

Mit diesen Refraktärmetall-Schichten ergeben sich besonders harte und wärmeharte Folien, die gut als Prüfnadeln aber auch als Bonddrähte einsetzbar sind.

Ferner kann vorgesehen sein, dass die Cu-Schichten in einer Richtung parallel zur Dicke der Folie miteinander verbunden sind, insbesondere kaltverschweißt sind, oder aneinander angrenzen, wobei vorzugsweise die Cu-Schichten eine zusammenhängende Matrix bilden, in der die Refraktärmetall-Schichten angeordnet sind, wobei besonders bevorzugt die Cu-Schichten auch in der Richtung parallel zur Dicke der Folie eine zusammenhängende Matrix bilden.

Hierdurch wird erreicht, dass die Folie eine hohe elektrische Leitfähigkeit hat und gleichzeitig durch die Refraktärmetall-Schichten mechanisch stabilisiert und gehärtet ist. Diese Mischung aus der vom Kupfer herrührenden hohen elektrischen Leitfähigkeit und der durch die eingeschlossenen Refraktärmetall-Schichten erreichten hohen Härte und Wärmefestigkeit, also der Härte der Folie und aus der Folie hergestellter Prüfnadeln und Bonddrähte auch bei erhöhten Temperaturen von bis zu 200 °C, macht die Folie insbesondere für Prüfnadeln aber auch für Bonddrähte gut einsetzbar. Die Richtung parallel zur Dicke der Folie ist vorzugsweise senkrecht zu den Cu-Schichten ausgerichtet.

Des Weiteren kann vorgesehen sein, dass die Folie eine elektrische Leitfähigkeit von zumindest $5 \cdot 10^6$ A/(V m) in einer Ebene senkrecht zur Dicke der Folie aufweist, bevorzugt eine elektrische Leitfähigkeit von zumindest 10 $10^6$ A/(V m) in der Ebene senkrecht zur Dicke der Folie aufweist, besonders bevorzugt eine elektrische Leitfähigkeit von zumindest 20 $10^6$ A/(V m) in der Ebene senkrecht zur Dicke der Folie aufweist.

Hierdurch ist die Folie aufgrund ihrer hohen elektrischen Leitfähigkeit bei gleichzeitig hoher Härte und Wärmefestigkeit gut zur Herstellung von Prüfnadeln oder zur Herstellung von Bonddrähten geeignet.

Bevorzugt ist die elektrische Leitfähigkeit in der Richtung parallel zur Dicke der Folie um mindestens 50% geringer als in der Ebene senkrecht zur Dicke der Folie, bevorzugt maximal halb so groß wir in der Ebene in der Ebene senkrecht zur Dicke der Folie der Folie.

Zur Messung wird eine Vierpunkt-Messmethode verwendet. Die Vierpunkt-Messmethode, auch Vierpunktmessung oder Vierspitzenmessung, ist ein Verfahren, um den Flächenwiderstand, also den elektrischen Widerstand einer Oberfläche oder dünnen Schicht, zu ermitteln. Bei dem Verfahren werden vier Messspitzen in einer Reihe auf die Oberfläche der Folie gebracht, wobei über die beiden Äußeren ein bekannter Strom fließt und mit den beiden Inneren der Potentialunterschied, das heißt, die elektrische Spannung zwischen diesen Spitzen, gemessen wird. Da das Verfahren auf dem Prinzip der Vierleitermessung beruht, ist es weitgehend unabhängig vom Übergangswiderstand zwischen den Messspitzen und der Oberfläche (Prinzip Thomson-Brücke). Benachbarte Messspitzen haben jeweils den gleichen Abstand.

Der Flächenwiderstand $R$ ergibt sich aus der gemessenen Spannung $U$ und dem Strom $I$ nach der Formel:

$$R = \frac{\pi}{\ln 2} \frac{U}{I}$$

Um aus dem Flächenwiderstand $R$ den spezifischen Widerstand $\rho$ des Schichtmaterials zu errechnen, multipliziert man ihn mit der Dicke $d$ (Schichtdicke) der Folie:

$$\rho = d\, R$$

Die elektrische Leitfähigkeit ergibt sich aus dem Kehrwert des spezifischen Widerstands.

Es kann vorgesehen sein, dass die Folie eine Nanoindentierungs-Härte von zumindest 4 GPa in einer Ebene senkrecht zur Dicke der Folie aufweist, vorzugsweise eine Härte von zumindest 5 GPa in der Ebene senkrecht zur Dicke der Folie aufweist.

Die angegebene Härte bezieht sich dabei auf Raumtemperatur (25 °C). Zur Messung wurde ein Nanoindenter mit einer Kontinuierlichen-Steifigkeits-Messungs-Einheit (CSM "continuous stiffness measurement testing unit") verwendet, mit der eine kontinuierliche Auswertung der Härte bei Temperaturen bis 1000 °C möglich ist. Hierzu wurde eine kontinuierlich ansteigende Kraft mit einer Spitze von 120 mN und einer Toleranz von ± 50 mN verwendet. Als Indentierungsspitze wurde eine Wolframcarbid-Spitze nach Berkovich ein sogenannter "Berkovich indenter" verwendet. Die Nanoindentierungs-Messungen erfolgten gemäß W. C. Oliver, G. M. Pharr, Journal of Materials Research, 1992, 1564 mit den zuvor angegebenen Parametern und einem Aufbau, wie er aus J.M. Wheeler, et al. Curr Opin Solid St M 19 (2015) 354-366 bekannt ist.

Es kann auch vorgesehen sein, dass der Schichtverbund der Folie eine Vickers-Härte HV0,1 von zumindest 150 in einer Richtung parallel zur Dicke der Folie aufweist, vorzugsweise eine Vickers-Härte HV0,1 von zumindest 250 in einer Richtung parallel zur Dicke der Folie aufweist.

Die Vickers-Härte HV0,1 wird dabei mit einer Kraft von 0,1 N in Richtung der Dicke der Folie gemessen. Die Messung der Vickers-Härte erfolgt gemäß DIN EN ISO 6507-1:2018 bis -4:2018: DIN Deutsches Institut für Normung e.V.: Metallische Werkstoffe - Härteprüfung nach Vickers - Teil 1: Prüfverfahren.

Bei dieser Härte kann eine aus der Folie gefertigte Prüfnadel mehrfach zur Messung einer Kontaktierung verwendet werden, ohne dass sich diese zu stark verformt oder abnutzt.

Gemäß einer bevorzugten Weiterbildung der vorliegenden Erfindung kann vorgesehen sein, dass die maximalen Schichtdicken der Cu-Schichten und/oder die maximalen Schichtdicken der Refraktärmetall-Schichten kleiner als 1 μm sind, vorzugsweise kleiner als 100 nm sind.

Hierdurch wird eine ausreichende Härtung der Folie sichergestellt.

Unter einer maximalen Schichtdicke wird vorliegend die maximale lokale Schichtdicke verstanden. Es kann sein und ist insbesondere bei sehr dünnen Schichtdicken so, dass lokal erheblich größere Dicken der Schichten erreicht werden als eine über die gesamte Fläche senkrecht zur Dicke der Folie gemittelte Schichtdicke. Die Schichtdicken können anhand von Querschliffen der Folie mit dem Rasterelektronenmikroskop (REM) bestimmt werden.

Auch die gemittelten Schichtdicken können durch die Herstellung (wie beispielsweise das Falten) geringfügig unterschiedlich groß werden und dabei in beschränktem Rahmen variieren.

Des Weiteren kann vorgesehen sein, dass der Anteil der Refraktärmetall-Schichten in dem gesamten Schichtverbund der Folie zwischen 3 Gew% und 30 Gew% liegt, bevorzugt zwischen 5 Gew% und 25 Gew%, besonders bevorzugt zwischen 15 Gew% und 20 Gew%.

Der Rest der Masse des Schichtverbunds der Folie entfällt vorzugsweise auf die Cu-Schichten.

Hierdurch kann eine Kupfer-Matrix oder eine Kupfer-Basis-Legierungs-Matrix bereitgestellt werden, die eine hohe elektrische Leitfähigkeit garantiert und gleichzeitig eine hohe mechanische Festigkeit durch eine hierfür ausreichende Menge an Refraktärmetall-Schichten erreicht werden.

Ferner kann vorgesehen sein, dass die Cu-Schichten aus einer Kupfer-Basis-Legierung mit einem Silber-Gehalt zwischen 2 Gew% und 8 Gew% bestehen, vorzugsweise aus einer CuAg3-Legierung oder einer CuAg7-Legierung bestehen.

Eine CuAg3-Legierung ist eine Kupfer-Basis-Legierung mit 3 Gew% Silber (Ag) und dem Rest Kupfer. Eine CuAg7-Legierung ist eine Kupfer-Basis-Legierung mit 7 Gew% Silber und dem Rest Kupfer. Zusätzlich sind selbstverständlich noch übliche Verunreinigungen vorhanden.

Mit diesem Silber-Gehalt ergibt sich eine hohe elektrische Leitfähigkeit bei gleichzeitig erhöhter mechanischer Härte der Cu-Schichten.

Gemäß einer Weiterbildung kann vorgesehen sein, dass die Refraktärmetall-Schichten teilweise lokal begrenzte Einschlüsse zwischen den Cu-Schichten bilden, wobei vorzugsweise die Einschlüsse sich in einer Breiten-Richtung senkrecht zur Dicke der Folie zwischen 10 μm und 1000 μm erstrecken und in einer Dicken-Richtung parallel zur Dicke der Folie zwischen 50 nm und 20 μm erstrecken und/oder wobei vorzugsweise die Einschlüsse in der Breiten-Richtung senkrecht zur Dicke der Folie zumindest doppelt so groß sind, insbesondere zumindest fünfmal so groß sind, wie in der Dicken-Richtung parallel zur Dicke der Folie.

Hierdurch wird eine hohe mechanische Härtung der Folie erreicht, ohne dabei die elektrische Leitfähigkeit der Cu-Schicht wesentlich zu verringern.

Bevorzugt kann auch vorgesehen sein, dass die Folie eine Dicke von mindestens 1 μm aufweist, bevorzugt eine Dicke von mindestens 3 μm aufweist, ganz besonders bevorzugt von zumindest 6 μm aufweist.

Hierdurch wird sichergestellt, dass insbesondere aus der Folie hergestellten Prüfnadeln aber auch aus der Folie hergestellten Bonddrähte eine ausreichende Dicke haben, damit keine zu großen Stromdichten in den Prüfnadeln und Bonddrähten auftreten. Hierdurch wird eine zu große Temperaturerhöhung der Prüfnadeln und Bonddrähte bei Stromleitung vermieden. Dünnere Folien sind mit Kaltwalzverfahren nur mit erheblichem zusätzlichem Aufwand zu fertigen. Zudem sind dünnere Folien nicht mehr kostengünstig weiterverarbeitbar.

Die der vorliegenden Erfindung zugrundeliegenden Aufgaben werden auch gelöst durch ein Verfahren zur Herstellung einer Prüfnadel oder eines Bonddrahts aus einer Folie, mit den Schritten:

1) Bereitstellen eines ersten Blechs aus Kupfer oder aus einer Kupfer-Basis-Legierung mit zumindest 90 Gew% Kupfer oder zweier erster Bleche aus Kupfer und/oder aus einer Kupfer-Basis-Legierung mit zumindest 90 Gew% Kupfer;

2) Bereitstellen eines zweiten Blechs aus Niob oder aus einer Niob-Basis-Legierung mit zumindest 90 Gew% Niob oder aus Tantal oder aus einer Tantal-Basis-Legierung mit zumindest 90 Gew% Tantal oder aus einer Refraktärmetall-Legierung mit zumindest 90 Gew% zumindest eines Refraktärmetalls aus der Gruppe Niob, Tantal, Vanadium, Wolfram, Molybdän und Chrom;

3) Übereinanderlegen des ersten Blechs und des zweiten Blechs oder Legen des zweiten Blechs zwischen die zwei ersten Bleche;

4) anschließendes Kaltwalzen des ersten Blechs und des zweiten Blechs oder der zwei ersten Bleche und des zweiten Blechs, so dass diese miteinander kaltverschweißen und einen Schichtverbund bilden;

5) Falten des Schichtverbunds durch Trennen des Schichtverbunds, Übereinanderlegen der Teile des Schichtverbunds und Kaltwalzen der übereinandergelegten Teile des Schichtverbunds oder durch Knicken des Schichtverbunds, Übereinanderlegen der abgeknickten Teile des Schichtverbunds und Kaltwalzen der übereinandergelegten Teile des Schichtverbunds, wobei das Falten zumindest siebenmal wiederholt wird, um einen mehrfach gefalteten Schichtverbund zu erhalten;

6) Walzen des mehrfach gefalteten Schichtverbunds auf eine Dicke von maximal 100 μm, sofern der mehrfach gefaltete Schichtverbund eine größere Dicke aufweist; und

7) Schneiden oder Stanzen der so hergestellten Folie und dadurch Herstellung der Prüfnadel oder des Bonddrahts aus der Folie.

Unter einem Falten wird im Rahmen der vorliegenden Erfindung also auch ein Verfahrensschritt verstanden, bei dem der Schichtverbund in Teile geschnitten wird und die auseinandergeschnittenen Teile übereinandergelegt werden, um diese anschließend zu walzen.

Dabei kann vorgesehen sein, dass mit dem Verfahren eine erfindungsgemäße Prüfnadel oder ein erfindungsgemäßer Bonddraht hergestellt wird.

Hierdurch ergeben sich für das Verfahren die gleichen Vorteile wie für die Folie.

Ferner kann vorgesehen sein, dass vor dem Übereinanderlegen des ersten Blechs und des zweiten Blechs zumindest die zum kaltverschweißen vorgesehenen Oberflächen des ersten Blechs und/oder des zweiten Blechs aufgeraut werden, insbesondere durch Bürsten aufgeraut werden, oder vor dem Legen des zweiten Blechs zwischen die zwei ersten Bleche zumindest die zum kaltverschweißen vorgesehenen Oberflächen des ersten Blechs und/oder des zweiten Blechs aufgeraut werden, insbesondere durch Bürsten aufgeraut werden, wobei vorzugsweise alle zum kaltverschweißen vorgesehenen Oberflächen des ersten Blechs oder der zwei ersten Bleche und/oder des zweiten Blechs aufgeraut werden, besonders bevorzugt durch Bürsten mit einer Metallbürste aufgeraut werden.

Hierdurch kann der Schichtverbund miteinander verzahnt werden, so dass sich die Schichten besser miteinander verbinden und weniger stark dazu neigen, sich innerhalb einer Ebene senkrecht zur Dicke der Folie zu separieren und dadurch zu dicke Einschlüsse bezüglich der Dicke der zu erzeugenden Folie zu bilden.

Die der vorliegenden Erfindung zugrundeliegenden Aufgaben werden ferner gelöst durch eine Prüfnadel zur Messung einer elektrischen Kontaktierung hergestellt aus einer Folie oder mit einem solchen Verfahren, wobei die Prüfnadel eine Dicke zwischen 2 μm und 100 μm aufweist.

Die Prüfnadel kann an ihrer Oberfläche mit einem Metall beschichtet sein. Bevorzugt kann die Prüfnadel an ihrer Oberfläche mit Gold, Silber, Platin, Palladium oder einer Basislegierung mit wenigstens einem dieser Elemente beschichtet sein.

Die der vorliegenden Erfindung zugrundeliegenden Aufgaben werden schließlich auch gelöst durch einen Bonddraht zur elektrischen Kontaktierung eines Chips hergestellt aus einer Folie oder mit einem solchen Verfahren, wobei der Bonddraht einen Querschnitt zwischen 2 μm und 100 μm aufweist.

Der Erfindung liegt die überraschende Erkenntnis zugrunde, dass es durch eine 100 μm dicke Folie aufweisend einen Schichtverbund von vielen dünnen Cu-Schichten und vielen dünnen Refraktärmetall-Schichten gelingt, ein Material bereitzustellen, aus dem auf einfache Weise Prüfnadeln oder Bonddrähte geschnitten oder gestanzt werden können, die in entlang ihrer Länge eine hohe elektrische Leitfähigkeit aufweisen, die vom Kupfer resultiert, gleichzeitig aber auch eine große Härte und Wärmefestigkeit aufweisen, die von den beim Verbinden der Cu-Schichten und Refraktärmetall-Schichten entstehenden Anteilen des Refraktärmetalls oder der Refraktärmetalle zwischen den Cu-Schichten resultiert. Durch Kaltwalzen und Falten der Ausgangsmaterialien Kupfer und Refraktärmetall miteinander wird eine stabile Verbindung erzeugt, die mechanisch gut für den Einsatz als Prüfnadel und als Bonddraht beziehungsweise Bondbändchen geeignet ist.

Übereinander liegende Bleche (zum Beispiel Cu-Nb-Cu) werden so miteinander verwalzt, dass sie kaltverschweißen und einen laminierten Schichtverbund in Form eines Blechs bilden. Dieses wird geteilt, übereinandergelegt und wieder miteinander verwalzt. Bei jedem dieser Walzschritte verdoppelt sich die Lagenanzahl und die Anzahl der Grenzflächen (Cu-Nb im Beispiel). Bei Lagenanzahlen von mehr als 500 bis 1000, beziehungsweise Lagendicken von kleiner 1 μm tritt neben der Kaltverfestigung ein zusätzlicher Härtungseffekt durch die Grenzflächen beziehungsweise die geringe Lagendicke auf. Diese Härtungseffekt wird bei gleichzeitig hoher elektrischer Leitfähigkeit erfindungsgemäß genutzt.

Die über Walzen hergestellten Metall-Schichtverbunde ermöglichen eine Kombination einer hohen elektrischen Leitfähigkeit mit einer hohen mechanischen Festigkeit, die auch bei erhöhter Temperatur erhalten bleibt (hohe Warmfestigkeit).

Das verwendet Verfahren (auch "accumulative roll bonding", kurz ARB genannt) und der dabei auftretende Härtungseffekt war für die Anwendung des Verfahrens zur Herstellung hoch leitfähiger Materialien für die Anwendung als Prüfnadeln oder Bondbändchen, welche trotz ihrer Nanostrukturierung eine gute Warmfestigkeit aufweisen, nicht bekannt.

Im Folgenden werden Ausführungsbeispiele der Erfindung anhand von elf Figuren erläutert, ohne jedoch dabei die Erfindung zu beschränken. Dabei zeigt:

Figur 1: eine Aufnahme mit einem Raster-Elektronen-Mikroskop (REM) eines Querschliffs durch einen 6-fach gefalteten kaltgewalzten Cu-Nb-Schichtverbund als Zwischenprodukt bei der Herstellung einer erfindungsgemäßen Folie;

Figur 2: eine Aufnahme mit einem REM eines Querschliffs durch einen 8-fach gefalteten kaltgewalzten Cu-Nb-Schichtverbund als Zwischenprodukt bei der Herstellung einer erfindungsgemäßen Folie;

Figur 3: eine Aufnahme mit einem REM eines Querschliffs durch einen 12-fach gefalteten kaltgewalzten Cu-Nb-Schichtverbund als Zwischenprodukt bei der Herstellung einer erfindungsgemäßen Folie;

Figur 4: eine Vergrößerung eines Bereichs der Aufnahme nach Figur 3;

Figur 5: eine Aufnahme mit einem REM eines Querschliffs durch einen 14-fach gefalteten kaltgewalzten Cu-Nb-Schichtverbund als Zwischenprodukt bei der Herstellung einer erfindungsgemäßen Folie;

Figur 6: eine Vergrößerung eines Bereichs der Aufnahme nach Figur 5;

Figur 7: eine Aufnahme mit einem REM eines Querschliffs durch eine 12-fach gefaltete erfindungsgemäße etwa 42 μm dicke Folie aus Cu-Schichten und Nb-Schichten;

Figur 8: eine Aufnahme mit einem REM eines Querschliffs durch eine 14-fach gefaltete erfindungsgemäße ca. 44 μm dicke Folie aus Cu-Schichten und Nb-Schichten;

Figur 9: eine Vergrößerung eines Bereichs der Aufnahme nach Figur 7; und

Figur 10: eine weitere Vergrößerung eines Bereichs der Aufnahme nach Figur 7; und

Figur 11: ein Diagramm der Vickers-Härte gegen die elektrische Leitfähigkeit mit Messwerten verschiedener erfindungsgemäßer Folien im Vergleich zu reinem Kupfer und reinem Niob.

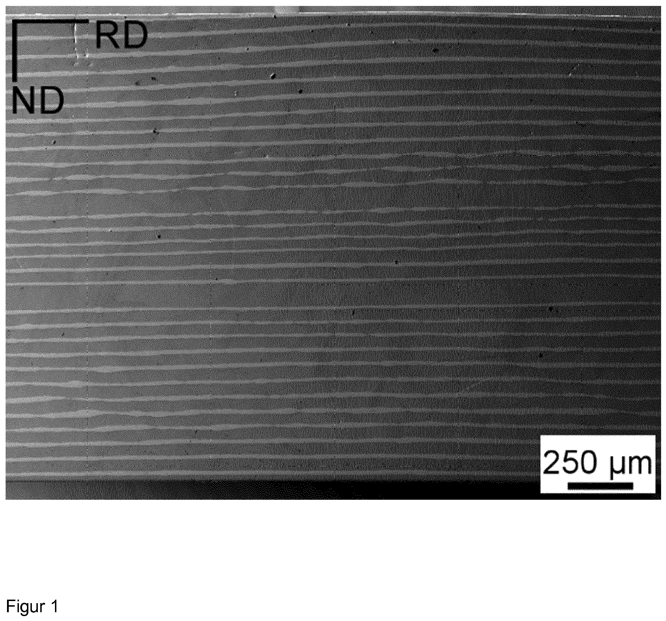

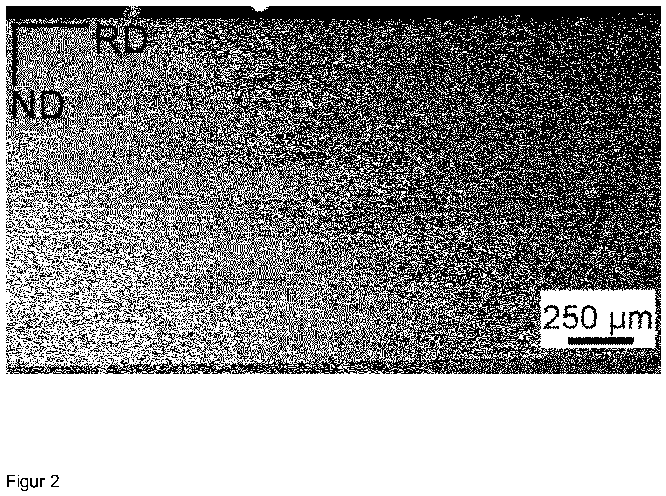

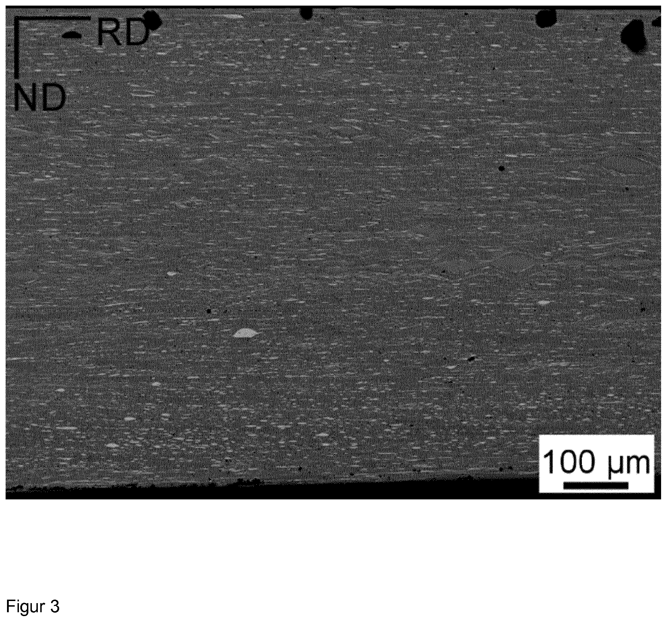

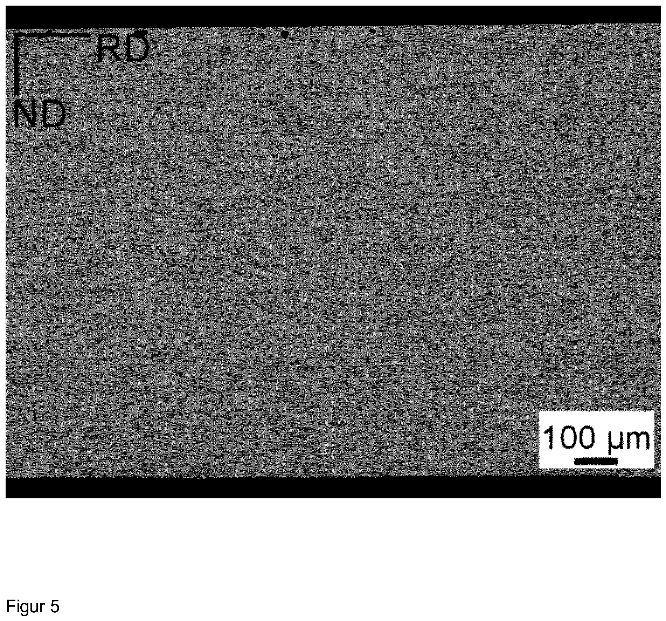

Die Figur 1 zeigt eine Aufnahme mit einem Raster-Elektronen-Mikroskop (REM) eines Querschliffs durch einen sechsfach gefalteten kaltgewalzten Cu-Nb-Schichtverbund (N6) als Zwischenprodukt bei der Herstellung einer erfindungsgemäßen Folie. In den Figuren 2 bis 6 sind achtfach gefaltete Cu-Nb-Schichtverbunde (N8), zwölffach gefaltete Cu-Nb-Schichtverbunde (N12) und vierzehnfach gefaltete Cu-Nb-Schichtverbunde (N14) als Querschliffe gezeigt.

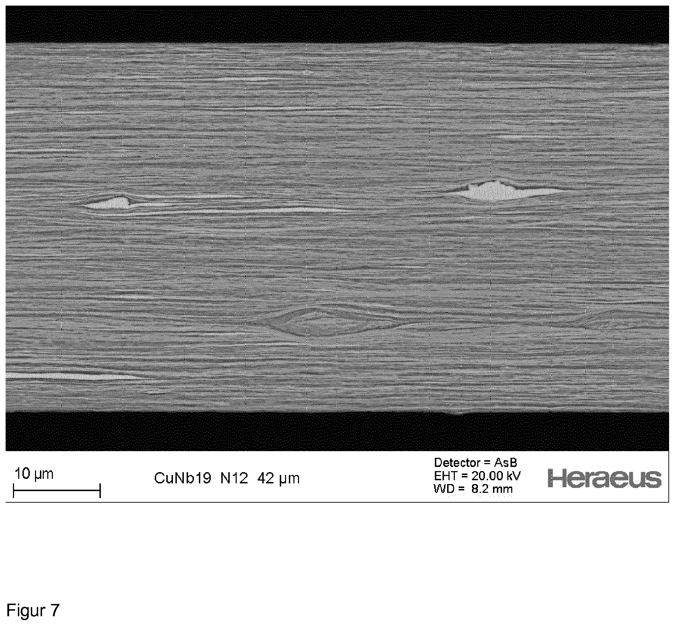

Die Figuren 7 bis 10 zeigen Aufnahmen mit einem REM von Querschliffen von erfindungsgemäßen Folien aus Cu-Schichten (dunkel) und Nb-Schichten (hell). Die Folien haben einen Anteil von 19 Gew% Nb und dem Rest Kupfer, einschließlich üblicher Verunreinigungen.

Zur Herstellung der erfindungsgemäßen Folie und die Schichtverbunde werden zunächst ein Cu-Nb-Schichtverbund durch Kaltwalzen aus zwei 2 mm dicken Kupfer-Blechen und einem 1 mm dickem Niob-Blech gefertigt. Die Kupfer-Bleche und das Niob-Blech wurden im Lieferzustand gewalzt. Die Kupfer-Bleche bestehen aus OFE-Cu mit der Werkstoffbezeichnung "CW008A". Das Niob-Blech besteht aus Niob mit der Werkstoffbezeichnung "R04200 type 1" und hat einen Nb-Gehalt von mindestens 99,8% mit bis zu 0,1% Ta und wurde von der Firma WHS Sondermetalle e.K. geliefert.

Durch mehrfaches Falten durch Trennen des Schichtverbunds, Aufeinanderlegen der getrennten Teile des Schichtverbunds und durch Kaltwalzen der aufeinander angeordneten Teile des Schichtverbunds, werden immer mehr Cu-Schichten und Nb-Schichten in dem Schichtverbund erzeugt. Das Kaltwalzen erfolgt bei Raumtemperatur mit einer Walze von Carl Wezel BW 300/350 und bei einer Walzgeschwindigkeit von 8 m/min.

Die Herstellung der Schichtverbunde erfolgt mit einem ARB-Verfahren, so wie es in T. Nizolek et. al.: "Processing and Deformation Behavior of Bulk Cu-Nb Nanolaminates", Metallogr. Microstruct. Anal. (2014) 3, 470-476 beschrieben ist. Bei der Herstellung der Schichtverbunde werden ARB-Zyklenzahlen von N4 (vierfach gefaltet), N6 (sechsfach gefaltet), N8 (achtfach gefaltet); N12 (zwölffach gefaltet) und N14 (vierzehnfach gefaltet) verwendet. Zur Herstellung der Folien wurden diese anschließend durch Kaltwalzen auf eine Dicke von etwa 43 $\mu$m gewalzt. Während des ARB-Verfahrens erfolgte eine Stichabnahme von jeweils 50-60 %.

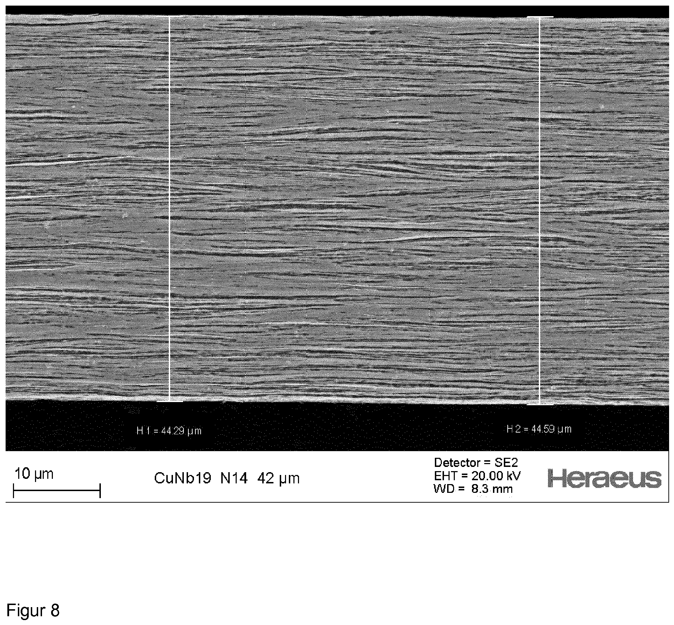

Die Folien nach den Figuren 7, 9 und 10 wurden zwölfmal gefaltet und die Folie nach Figur 8 wurde vierzehnmal gefaltet und anschließend bis zur gewünschte Dicke gewalzt.

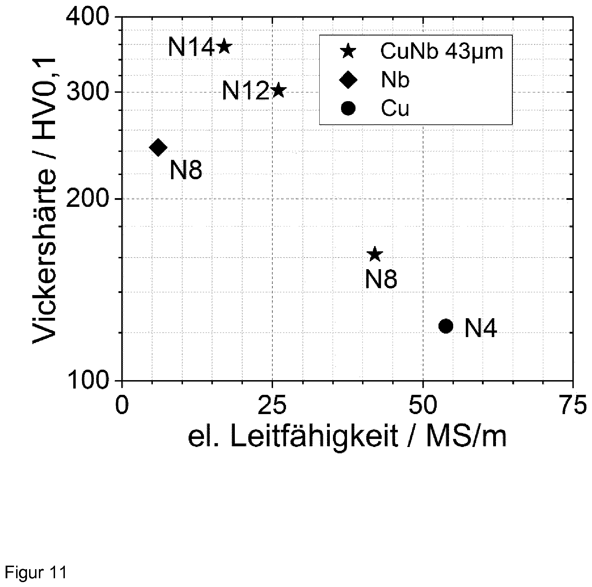

Zur Untersuchung erfolgt eine Charakterisierung der Lagenarchitektur und Mikrostruktur mit Hilfe von Rasterelektronenmikroskopie. Hierzu werden die Schichtverbunde als Zwischenprodukt in einer Richtung parallel zur Dicke der Schichtverbunde geschliffen. Ebenso wurden die Folien in einer Richtung parallel zur Dicke der Folien geschliffen. Der Kontrast im REM entsteht durch Rückstreuelektronen, so dass das Niob in den Figuren 1 bis 10 heller erscheint als das Kupfer. Ferner erfolgten eine Vickers-Härtemessung in Richtung der Dicke der Folie und eine Messung der elektrischen Leitfähigkeit in einer Richtung senkrecht zur Dicke der Folie. Die Ergebnisse hierzu sind in Figur 11 dargestellt.

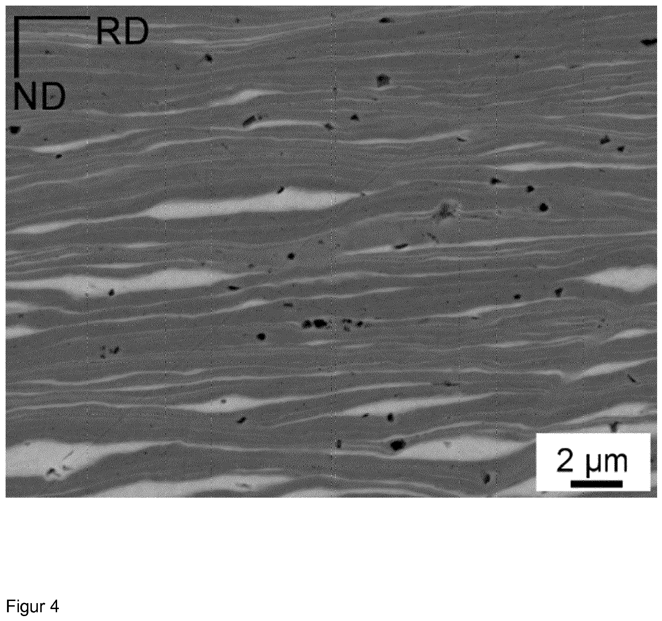

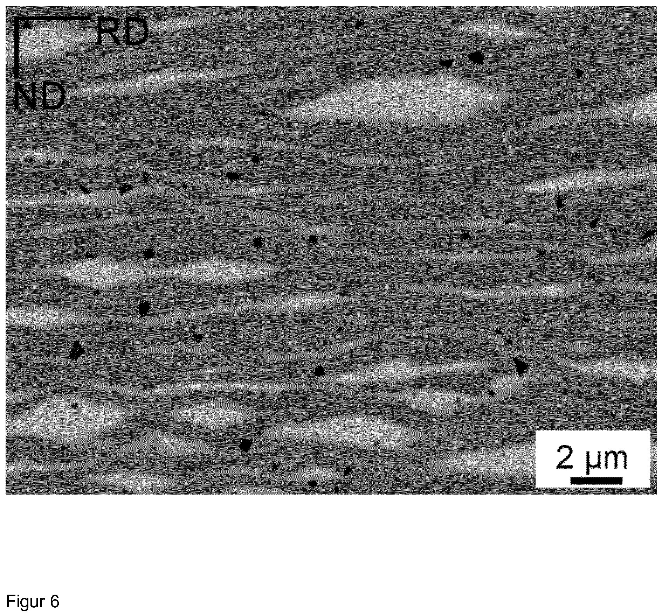

In den Vergrößerungen der Figuren 4 und 6 ist zu erkennen, dass die Nb-Schichten im Gegensatz zu den Nb-Schichten nach Figur 1 nicht mehr als gleichmäßig dicke Schichten in dem Schichtverbund vorliegen. Stattdessen ist bei den Faltungen und dem Kaltwalzen eine Schichtstruktur mit lokalisierten Nb-Einschlüssen entstanden, um die herum die Cu-Schichten angeordnet sind. Durch die von den Nb-Einschlüssen verursachten Verformungen der Cu-Schichten und durch die Nb-Einschlüsse selbst kommt es auch zu einer Verfestigung des Schichtverbunds aufgrund von Behinderungen der Versetzungsausbreitung in dem Material. Gleichzeitig kommen die Kupfer-Schichten an verschiedenen Stellen im Schichtverbund miteinander in Kontakt, so dass die elektrische Leitfähigkeit maßgeblich durch das Kupfer bestimmt wird. Eine vollständige Auftrennung der Nb-Schichten ist jedoch nicht erwünscht, da der Härtungseffekt bei noch vorhandener Schichtstruktur größer ist.

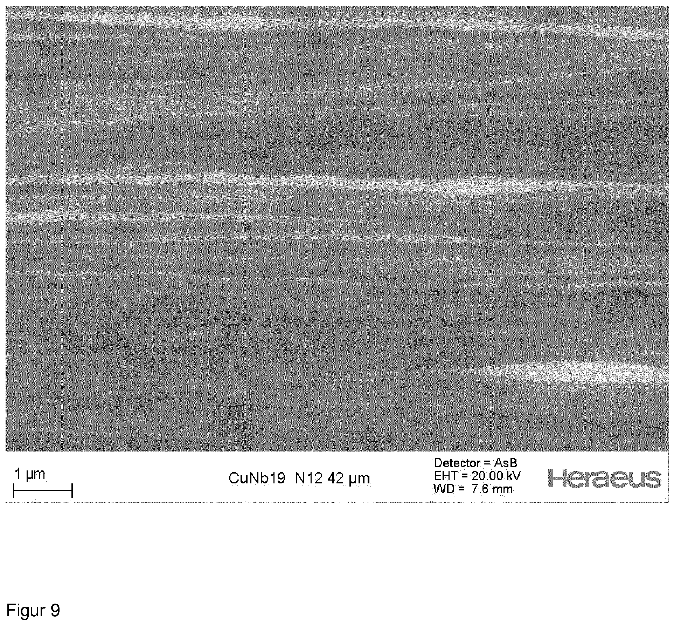

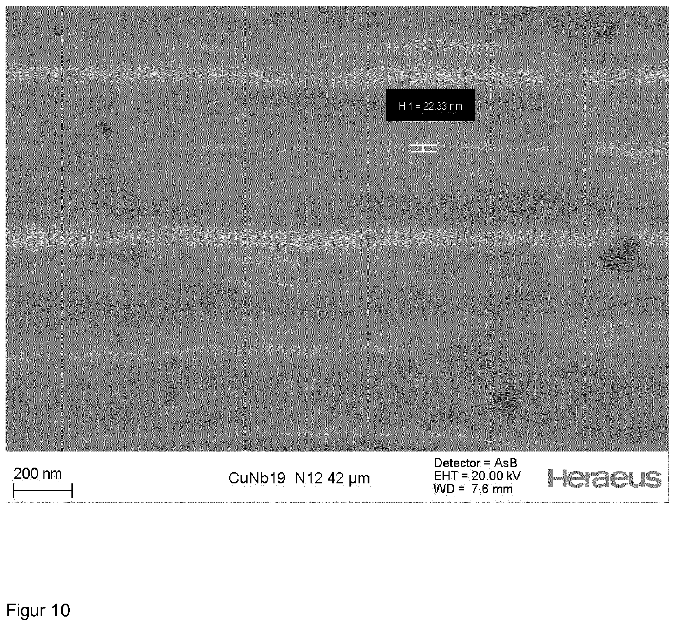

In den Figuren 7 bis 10 ist zu erkennen, dass sich lokale Nb-Einschlüsse im Schichtverbund bilden (siehe vor allem Figuren 7 und 9). Dennoch bleibt die Schichtstruktur in der Folie erhalten. Die Nb-Schichten sind teilweise nur noch etwa 20 nm dick (siehe Figur 10).

Wie in Figur 11 zu erkennen ist, ergibt sich bereits ab einer achtfachen Faltung (N8) eine etwas größere Vickers-Härte als für reines Kupfer (Cu), bei nur geringfügig verringerter elektrischer Leitfähigkeit im Vergleich zu reinem Kupfer. Bei einer zwölffachen Faltung (N12) und bei einer vierzehnfachen Faltung (N14) ergibt sich eine erheblich größere Vickers-Härte, die auch die Vickers-Härte von reinem Niob (Nb) übertrifft. Gleichzeitig ergibt sich eine elektrische Leitfähigkeit, die über 15 MS/m liegt und damit nicht sehr weit unter der von reinem Kupfer aber über der von reinem Niob. Wie sich an den Messungen zu N12 und N14 zeigt, führt eine weitere Faltung nicht zwingend zu einer wesentlichen höheren Vickers-Härte bei gleichzeitig abnehmender elektrischer Leitfähigkeit. Daher wird erfindungsgemäß eine zehnfache bis vierzehnfache Faltung (N10 bis N14) bevorzugt. Ganz besonders bevorzugt wird die zwölffache Faltung (N12).

Die Vickers-Härte HV0,1 wird für die in Figur 11 gezeigten Messwerte mit einer Kraft von 0,1 N in Richtung der Dicke der Folie gemessen. Die Messung der Vickers-Härte erfolgt gemäß DIN EN ISO 6507-1:2018 bis -4:2018: DIN Deutsches Institut für Normung e.V.: Metallische Werkstoffe - Härteprüfung nach Vickers - Teil 1: Prüfverfahren. Es handelt sich um eine Vickers-Mikrohärteprüfung.

Die elektrische Leitfähigkeit wird bestimmt durch eine Vierpunkt-Messmethode.

Die erfindungsgemäßen Folien N8 und besonders N12 und N14 zeichnen sich durch eine hohe Härte bei gleichzeitig guter elektrischer Leitfähigkeit aus. Zudem sind die Folien mit ca. 43 µm Dicke so dünn, dass aus den so gefertigten Folien unmittelbar Prüfnadeln oder Bonddrähte durch Ausschneiden aus den Folien gewonnen werden können. Durch die dünnen Cu-Schichten und Nb-Schichten ergibt sich aber dennoch ein über den Querschnitt der Folie weitgehend homogenes Material. Die aus den Folien gefertigten Prüfnadeln nutzen sich aufgrund ihrer Härte nur langsam ab und leiten gleichzeitig den elektrischen Strom zum Prüfen einer Kontaktierung gut, so dass eine große Anzahl von elektrischen Kontakten bei hoher Empfindlichkeit der Messung geprüft werden kann, bevor die Prüfnadeln ausgetauscht werden müssen. Für die Bonddrähte oder Bondbändchen aus den erfindungsgemäßen Folien gilt, dass diese nur geringe Widerstandsverluste verursachen und gleichzeitig auch bei geringen Querschnitten einer mechanischen Belastung standhalten können. So kommt es bei einer guten elektrischen Kontaktierung zu geringen Ausschüssen bei der elektrischen Kontaktierung von Chips. Die Prüfnadeln oder Bonddrähte können zur Oberflächenvergütung mit einem oxidationsbeständigen Metall beschichtet werden. Hierzu kann beispielsweise Gold, Platin oder Palladium verwendet werden.

**Patentansprüche**

1. Prüfnadel zur Messung einer elektrischen Kontaktierung oder Bonddraht zur elektrischen Kontaktierung eines Chips, wobei die Prüfnadel oder der Bonddraht eine Folie aufweist, die Folie aufweisend eine Dicke von maximal 100 µm und die Folie aufweisend einen Schichtverbund aus

   Cu-Schichten aus Kupfer und/oder einer Kupfer-Basis-Legierung mit zumindest 90 Gew% Kupfer und
   Refraktärmetall-Schichten aus einem Refraktärmetall der Gruppe Niob und Tantal oder Refraktärmetall-Schichten aus einer Refraktärmetall-Basis-Legierung mit zumindest 90 Gew% zumindest eines Refraktärmetalls aus der Gruppe Niob, Tantal, Vanadium, Wolfram, Molybdän und Chrom,
   wobei der Schichtverbund zumindest 125 Cu-Schichten und 125 Refraktärmetall-Schichten pro 10 µm Dicke aufweist, und
   wobei die Prüfnadel eine Dicke zwischen 2 µm und 100 µm aufweist oder der Bonddraht einen Querschnitt zwischen 2 µm und 100 µm aufweist.

2. Prüfnadel oder Bonddraht nach Anspruch 1, wobei

   die Refraktärmetall-Schichten Nb-Schichten sind, die aus Niob oder einer Nb-Basis-Legierung mit zumindest 90 Gew% Niob bestehen, oder
die Refraktärmetall-Schichten Ta-Schichten sind, die aus Tantal oder einer Ta-Basis-Legierung mit zumindest 90 Gew% Tantal bestehen, oder
die Refraktärmetall-Schichten NbTa-Schichten sind, die aus einer NbTa-Legierung mit zumindest 90 Gew% NbTa bestehen.

3. Prüfnadel oder Bonddraht nach Anspruch 1 oder 2, wobei
die Cu-Schichten in einer Richtung parallel zur Dicke der Folie miteinander verbunden sind, insbesondere kaltverschweißt sind, oder aneinander angrenzen.

4. Prüfnadel oder Bonddraht nach Anspruch 3, wobei die Cu-Schichten eine zusammenhängende Matrix bilden, in der die Refraktärmetall-Schichten angeordnet sind, wobei besonders bevorzugt die Cu-Schichten auch in der Richtung parallel zur Dicke der Folie eine zusammenhängende Matrix bilden.

5. Prüfnadel oder Bonddraht nach einem der Ansprüche 1 bis 4, wobei
die Folie eine elektrische Leitfähigkeit von zumindest $5 \cdot 10^6$ A/(V m) in einer Ebene senkrecht zur Dicke der Folie aufweist, gemessen mit einer Vierpunkt-Messmethode, bevorzugt eine elektrische Leitfähigkeit von zumindest $10 \cdot 10^6$ A/(V m) in der Ebene senkrecht zur Dicke der Folie aufweist, besonders bevorzugt eine elektrische Leitfähigkeit von zumindest $20 \cdot 10^6$ A/(V m) in der Ebene senkrecht zur Dicke der Folie aufweist.

6. Prüfnadel oder Bonddraht nach einem der Ansprüche 1 bis 5, wobei
der Schichtverbund der Folie eine Vickers-Härte HV0,1 von zumindest 150 in einer Richtung parallel zur Dicke der Folie aufweist, wobei die Messung der Vickers-Härte gemäß DIN EN ISO 6507-1:2018 bis -4:2018: DIN Deutsches Institut für Normung e.V.: Metallische Werkstoffe - Härteprüfung nach Vickers - Teil 1: Prüfverfahren erfolgt, vorzugsweise eine Vickers-Härte HV0,1 von zumindest 250 in einer Richtung parallel zur Dicke der Folie aufweist.

7. Prüfnadel oder Bonddraht nach einem der Ansprüche 1 bis 6, wobei
die maximalen Schichtdicken der Cu-Schichten und/oder die maximalen Schichtdicken der Refraktärmetall-Schichten kleiner als 1 µm sind, vorzugsweise kleiner als 100 nm sind.

8. Prüfnadel oder Bonddraht nach einem der Ansprüche 1 bis 7, wobei
der Anteil der Refraktärmetall-Schichten in dem gesamten Schichtverbund der Folie zwischen 3 Gew% und 30 Gew% liegt, bevorzugt zwischen 5 Gew% und 25 Gew%, besonders bevorzugt zwischen 15 Gew% und 20 Gew%.

9. Prüfnadel oder Bonddraht nach einem der Ansprüche 1 bis 8, wobei
die Cu-Schichten aus einer Kupfer-Basis-Legierung mit einem Silber-Gehalt zwischen 2 Gew% und 8 Gew% bestehen, vorzugsweise aus einer CuAg3-Legierung oder einer CuAg7-Legierung bestehen.

10. Prüfnadel oder Bonddraht nach einem der Ansprüche 1 bis 9, wobei
die Refraktärmetall-Schichten teilweise lokal begrenzte Einschlüsse zwischen den Cu-Schichten bilden.

11. Prüfnadel oder Bonddraht nach Anspruch 10, wobei
die Einschlüsse sich in einer Breiten-Richtung senkrecht zur Dicke der Folie zwischen 10 $\mu$m und 1000 $\mu$m erstrecken und in einer Dicken-Richtung parallel zur Dicke der Folie zwischen 50 nm und 20 $\mu$m erstrecken und/oder die Einschlüsse in der Breiten-Richtung senkrecht zur Dicke der Folie zumindest doppelt so groß sind, insbesondere zumindest fünfmal so groß sind, wie in der Dicken-Richtung parallel zur Dicke der Folie.

12. Prüfnadel oder Bonddraht nach einem der Ansprüche 1 bis 11, wobei
die Folie eine Dicke von mindestens 1 $\mu$m aufweist, bevorzugt eine Dicke von mindestens 3 $\mu$m aufweist, ganz besonders bevorzugt von zumindest 6 $\mu$m aufweist.

13. Verfahren zur Herstellung einer Prüfnadel oder eines Bonddrahts aus einer Folie, **gekennzeichnet durch** die Schritte

Bereitstellen eines ersten Blechs aus Kupfer oder aus einer Kupfer-Basis-Legierung mit zumindest 90 Gew% Kupfer oder Bereitstellen zweier erster Bleche aus Kupfer und/oder aus einer Kupfer-Basis-Legierung mit zumindest 90 Gew% Kupfer;
Bereitstellen eines zweiten Blechs aus Niob oder aus einer Niob-Basis-Legierung mit zumindest 90 Gew% Niob oder aus Tantal oder aus einer Tantal-Basis-Legierung mit zumindest 90 Gew% Tantal oder aus einer Refraktärmetall-Legierung mit zumindest 90 Gew% zumindest eines Refraktärmetalls aus der Gruppe Niob, Tantal, Vanadium, Wolfram, Molybdän und Chrom;
Übereinanderlegen des ersten Blechs und des zweiten Blechs oder Legen des zweiten Blechs zwischen die zwei ersten Bleche;

anschließendes Kaltwalzen des ersten Blechs und des zweiten Blechs oder der zwei ersten Bleche und des zweiten Blechs, so dass diese miteinander kaltverschweißen und einen Schichtverbund bilden;
Falten des Schichtverbunds durch Trennen des Schichtverbunds, Übereinanderlegen der Teile des Schichtverbunds und Kaltwalzen der übereinandergelegten Teile des Schichtverbunds oder durch Knicken des Schichtverbunds, Übereinanderlegen der abgeknickten Teile des Schichtverbunds und Kaltwalzen der übereinandergelegten Teile des Schichtverbunds, wobei das Falten zumindest siebenmal wiederholt wird, um einen mehrfach gefalteten Schichtverbund zu erhalten;
Walzen des mehrfach gefalteten Schichtverbunds auf eine Dicke von maximal 100 $\mu$m, sofern der mehrfach gefaltete Schichtverbund eine größere Dicke aufweist; und
Schneiden oder Stanzen der so hergestellten Folie und dadurch Herstellung der Prüfnadel oder des Bonddrahts aus der Folie.

14. Verfahren nach Anspruch 13, wobei
mit dem Verfahren eine Prüfnadel oder ein Bonddraht nach einem der Ansprüche 1 bis 12 hergestellt wird.

15. Verfahren nach Anspruch 13 oder 14, wobei

vor dem Übereinanderlegen des ersten Blechs und des zweiten Blechs zumindest die zum kaltverschweißen vorgesehenen Oberflächen des ersten Blechs und/oder des zweiten Blechs aufgeraut werden, insbesondere durch Bürsten aufgeraut werden, oder
vor dem Legen des zweiten Blechs zwischen die zwei ersten Bleche zumindest die zum kaltverschweißen vorgesehenen Oberflächen des ersten Blechs und/oder des zweiten Blechs aufgeraut werden, insbesondere durch Bürsten aufgeraut werden.

16. Verfahren nach Anspruch 15, wobei
alle zum kaltverschweißen vorgesehenen Oberflächen des ersten Blechs oder der zwei ersten Bleche und/oder des zweiten Blechs aufgeraut werden, bevorzugt durch Bürsten mit einer Metallbürste aufgeraut werden.

**Claims**

1. Test needle for measuring an electrical contact or bonding wire for electrically contacting a chip, wherein the test needle or the bonding wire comprises a film, the film having a thickness of at most 100 $\mu$m,

and the film having a layered composite made up of Cu layers of copper and/or a copper-based alloy with at least 90 wt.% copper, and refractory metal layers of a refractory metal from the group of niobium and tantalum, or refractory metal layers of a refractory metal-based alloy with at least 90 wt.% of at least one refractory metal from the group of niobium, tantalum, vanadium, tungsten, molybdenum, and chromium,

wherein the layered composite comprises at least 125 Cu layers and 125 refractory metal layers per 10 $\mu$m thickness; and

wherein the test needle has a thickness of between 2 $\mu$m and 100 $\mu$m, or the bonding wire has a cross-section of between 2 $\mu$m and 100 $\mu$m.

2. The test needle or bonding wire according to claim 1, wherein

the refractory metal layers are Nb layers consisting of niobium or an Nb-based alloy with at least 90 wt.% niobium, or

the refractory metal layers are Ta layers consisting of tantalum or a Ta-based alloy with at least 90 wt.% tantalum, or

the refractory metal layers are NbTa layers consisting of an NbTa alloy with at least 90 wt.% NbTa.

3. The test needle or bonding wire according to claim 1 or 2, wherein

the Cu layers are bonded to one another, in particular cold welded, or are adjacent to one another in a direction parallel to the thickness of the film.

4. The test needle or bonding wire according to claim 3, wherein

the Cu layers form a contiguous matrix in which the refractory metal layers are arranged, wherein the Cu layers particularly preferably form a contiguous matrix also in the direction parallel to the thickness of the film.

5. The test needle or bonding wire according to any one of claims 1 to 4, wherein

the film has an electrical conductivity of at least 5 $10^6$ A/(V m) in a plane perpendicular to the thickness of the film, measured with a four-point measuring method; preferably has an electrical conductivity of at least 10 $10^6$ A/(V m) in the plane perpendicular to the thickness of the film; particularly preferably has an electrical conductivity of at least 20 $10^6$ A/(V m) in the plane perpendicular to the thickness of the film.

6. The test needle or bonding wire according to any one of claims 1 to 5, wherein

the layered composite of the film has a Vickers hardness HV0.1 of at least 150 in a direction parallel to the thickness of the film, wherein the measurement of the Vickers hardness is conducted according to DIN EN ISO 6507-1:2018 to -4:2018: DIN German Institute for Standardization: Metallic Materials - Vickers hardness test - Part 1: Test method, preferably has a Vickers hardness HV0.1 of at least 250 in a direction parallel to the thickness of the film.

7. The test needle or bonding wire according to any one of claims 1 to 6, wherein

the maximum layer thicknesses of the Cu layers and/or the maximum layer thicknesses of the refractory metal layers are less than 1 $\mu$m, preferably less than 100 nm.

8. The test needle or bonding wire according to any one of claims 1 to 7, wherein

the proportion of refractory metal layers in the entire layered composite of the film is between 3 wt.% and 30 wt.%, preferably between 5 wt.% and 25 wt.%, particularly preferably between 15 wt.% and 20 wt.%.

9. The test needle or bonding wire according to any one of claims 1 to 8, wherein

the Cu layers consist of a copper-based alloy having a silver content between 2 wt.% and 8 wt.%, preferably consist of a CuAg3 alloy or a CuAg7 alloy.

10. The test needle or bonding wire according to any one of claims 1 to 9, wherein

the refractory metal layers partially form locally limited inclusions between the Cu layers.

11. The test needle or bonding wire according to claim 10, wherein

the inclusions extend between 10 $\mu$m and 1000 $\mu$m in a width direction perpendicular to the thickness of the film, and extend between 50 nm and 20 $\mu$m in a thickness direction parallel to the thickness of the film, and/or

the inclusions in the width direction are at least twice as large, in particular at least five times as large, perpendicular to the thickness of the film as in the thickness direction parallel to the thickness of the film.

12. The test needle or bonding wire according to any one of claims 1 to 11, wherein

the film has a thickness of at least 1 $\mu$m, preferably has a thickness of at least 3 $\mu$m, very particularly preferably of at least 6 $\mu$m.

13. Method for producing a test needle or a bonding wire from a film, **characterized by** the steps of

providing a first metal sheet made of copper or of a copper-based alloy with at least 90 wt.% copper, or providing two first metal sheets made of copper and/or of a copper-based alloy with at least 90 wt.% copper;

providing a second metal sheet made of niobium, or of a niobium-based alloy with at least 90 wt.% niobium, or of tantalum, or of a tantalum-based alloy with at least 90 wt.% tantalum, or from a refractory metal alloy with at least 90 wt.% of at least one refractory metal from the group of niobium, tantalum, vanadium, tungsten, molybdenum, and chromium;

superimposing the first metal sheet and the second metal sheet, or placing the second metal sheet between the two first metal sheets;

subsequent cold rolling of the first metal sheet and the second metal sheet, or of the two first metal sheets and the second metal sheet, so that these cold weld to one another and form a layered composite;

folding the layered composite by separating the laminate structure, superimposing the parts of the layered composite and cold rolling the superimposed parts of the layered composite, or by bending the layered composite, superimposing the bent parts of the layered composite and cold rolling the superimposed parts of the layered composite, wherein the folding is repeated at least seven times to obtain a repeatedly folded layered composite; rolling the repeatedly folded layered composite to a thickness of at most 100 $\mu$m if the repeatedly folded layered composite has a greater thickness; and

cutting or punching the film thus produced, and thereby producing the test needle or the bonding wire from the film.

14. Method according to claim 13, wherein

the method produces a test needle or a bonding wire according to any one of claims 1 to 12.

15. Method according to claim 13 or 14, wherein,

before superimposing the first metal sheet and the second metal sheet, at least the surfaces of the first metal sheet and/or the second metal sheet provided for cold welding are roughened, in particular roughened by brushing, or

before placing the second metal sheet between the two first metal sheets, at least the surfaces of the first metal sheet and/or of the second metal sheet provided for cold welding are roughened, in particular roughened by brushing.

16. Method according to claim 15, wherein

all surfaces of the first metal sheet or of the two first metal sheets and/or of the second metal sheet provided for cold welding are roughened, preferably roughened by brushing with a metal brush.

**Revendications**

1. Aiguille d'essai destinée à la mesure d'un contact électrique ou fil de connexion destiné au contact électrique d'une puce, dans lequel l'aiguille d'essai ou le fil de connexion comporte une feuille, la feuille présentant une épaisseur de maximum 100 $\mu$m et la feuille présentant une structure en couches composée de

couches de Cu composées de cuivre et/ou d'un alliage à base de cuivre comportant au moins 90 % en poids de cuivre et

et des couches de métal réfractaire composées d'un métal réfractaire du groupe constitué par le niobium et le tantale ou des couches de métal réfractaire composées d'un alliage à base de métal réfractaire comportant au moins 90 % en poids d'un métal réfractaire du groupe constitué par le niobium, le tantale, le vanadium, le tungstène, le molybdène et le chrome,

la structure en couches comportant au moins 125 couches de Cu et 125 couches de métal réfractaire par 10 $\mu$m d'épaisseur, et

l'aiguille d'essai présentant une épaisseur dans la plage comprise entre 2 $\mu$m et 100 $\mu$m ou le fil de connexion présentant une coupe transversale dans la plage comprise entre 2 $\mu$m et 100 $\mu$m.

2. Aiguille d'essai ou fil de connexion selon la revendication 1, dans lequel les couches de métal réfractaire sont des couches de Nb, lesquelles sont composées de niobium ou d'un alliage à base de niobium comportant au moins 90 % en poids de niobium, ou

les couches de métal réfractaire sont des couches de Ta, lesquelles sont composées de tantale ou d'un alliage à base de Ta comportant au moins 90 % en poids de tantale, ou

les couches de métal réfractaire sont des couches de NbTa, lesquelles sont composées d'un alliage de NbTa comportant au moins 90 % en poids de NbTa.

3. Aiguille d'essai ou fil de connexion selon la revendication 1 ou 2, dans lequel les couches de Cu sont, dans une direction parallèle à l'épaisseur de la feuille, connectées les unes aux autres, en particulier soudées à froid, ou adjacentes les unes aux autres.

4. Aiguille d'essai ou fil de connexion selon la revendication 3, dans lequel les couches de Cu forment une matrice cohérente, dans laquelle sont disposées les couches de métal réfractaire, dans lequel, de préférence encore les couches de Cu forment aussi une matrice cohérente dans la direction parallèle à l'épaisseur de la feuille.

5. Aiguille d'essai ou fil de connexion selon l'une quelconque des revendications 1 à 4, dans lequel la feuille présente une conductivité électrique d'au moins $5 \cdot 10^6$ A/(V m) dans un plan perpendiculaire à l'épaisseur de la feuille, mesurée selon un procédé de mesure à quatre points, de préférence une conductivité électrique d'au moins $10 \cdot 10^6$ A/(V m) dans le plan perpendiculaire à l'épaisseur de la feuille, de préférence encore une conductivité électrique d'au moins $20 \cdot 10^6$ A/(V m) dans le plan perpendiculaire à l'épaisseur de la feuille.

6. Aiguille d'essai ou fil de connexion selon l'une quelconque des revendications 1 à 5, dans lequel la structure en couches de la feuille présente une dureté Vickers HV0,1 d'au moins 150 dans une direction parallèle à l'épaisseur de la feuille, dans lequel la mesure de la dureté Vickers est effectuée conformément aux normes DIN EN ISO 6507-1:2018 à -4:2018 : DIN Deutsches Institut für Normung e.V. : Matériaux métalliques - Essai de dureté Vickers - Partie 1 : Méthode d'essai, présente de préférence une dureté Vickers HV0,1 d'au moins 250 dans une direction parallèle à l'épaisseur de la feuille.

7. Aiguille d'essai ou fil de connexion selon l'une quelconque des revendications 1 à 6, dans lequel les épaisseurs de couche maximales des couches de Cu et/ou les épaisseurs de couche maximales des couches de métal réfractaire sont inférieures à 1 $\mu$m, de préférence inférieures à 100 nm.

8. Aiguille d'essai ou fil de connexion selon l'une quelconque des revendications 1 à 7, dans lequel la part des couches de métal réfractaire dans la structure en couches complète de la feuille se trouve dans la plage comprise entre 3 % en poids et 30 % en poids, de préférence entre 5 % en poids et 25 % en poids, de préférence encore entre 15 % en poids et 20 % en poids.

9. Aiguille d'essai ou fil de connexion selon l'une quelconque des revendications 1 à 8, dans lequel les couches de Cu sont composées d'un alliage à base de cuivre à une teneur en argent dans la plage comprise entre 2 % en poids et 8 % en poids, de préférence composées d'un alliage CuAg3 ou d'un alliage CuAg7.

10. Aiguille d'essai ou fil de connexion selon l'une quelconque des revendications 1 à 9, dans lequel les couches de métal réfractaire partiellement forment des inclusions limitées localement entre les couches de Cu.

11. Aiguille d'essai ou fil de connexion selon la revendication 10, dans lequel les inclusions s'étendent dans une direction de largeur perpendiculaire à l'épaisseur de la feuille dans la plage comprise entre 10 $\mu$m et 1 000 $\mu$m et s'étendent dans une direction d'épaisseur parallèle à l'épaisseur de la feuille dans la plage comprise entre 50 nm et 20 $\mu$m et/ou les inclusions sont au moins deux fois supérieures dans la direction de largeur perpendiculaire à l'épaisseur de la feuille, en particulier au moins cinq fois supérieures, qu'elles ne le sont dans la direction d'épaisseur parallèle à l'épaisseur de la feuille.

12. Aiguille d'essai ou fil de connexion selon l'une quelconque des revendications 1 à 11, dans lequel la feuille présente une épaisseur d'au moins 1 $\mu$m, de préférence une épaisseur d'au moins 3 $\mu$m, idéalement d'au moins 6 $\mu$m.

13. Procédé de fabrication d'une aiguille d'essai ou d'un fil de connexion à partir d'une feuille, **caractérisé par** les étapes suivantes

la fourniture d'une première tôle en cuivre ou en un alliage à base de cuivre comportant au moins 90 % en poids de cuivre ou la fourniture de deux premières tôles en cuivre et/ou en un alliage à base de cuivre comportant au moins 90 % en poids de cuivre ; la fourniture d'une seconde tôle en niobium ou en un alliage à base de niobium comportant au moins 90 % en poids de niobium ou en tantale ou en un alliage à base de tantale comportant au moins 90 % en poids de tantale ou en un alliage de métal réfractaire comportant au moins 90 % en poids d'un métal réfractaire du groupe constitué par le niobium, le tantale, le tungstène, le molybdène et le chrome ; la superposition de la première tôle et de la seconde tôle ou le placement de la seconde tôle entre les deux premières tôles ; le laminage à froid ultérieur de la première tôle et de la seconde tôle ou des deux premières tôles et de la seconde tôle de telle sorte que celles-ci sont soudées à froid entre elles et forment une structure en couches ; le pliage de la structure en couche par séparation de la structure en couches, la superposition des parties de la structure en couches et le laminage à froid des parties superposées de la structure en couches ou par pliage de la structure en couches, la superposition des parties pliées de la structure en couches et le laminage à froid des parties superposées de la structure en couches, dans lequel le pliage est répété au moins sept fois, pour obtenir une structure en couche pliée plusieurs fois ;

le laminage de la structure en couches pliée plusieurs fois à une épaisseur de maximum 100 μm, si la structure en couches pliée plusieurs fois présente une épaisseur supérieure ; et le découpage ou l'estampage de la feuille fabriquée ainsi et ainsi fabrication de l'aiguille d'essai ou du fil de connexion à partir de la feuille.

14. Procédé selon la revendication 13, dans lequel une aiguille d'essai ou un fil de connexion selon l'une quelconque des revendications 1 à 12 est fabriqué au selon le procédé.

15. Procédé selon la revendication 13 ou 14, dans lequel

avant la superposition de la première tôle et de la seconde tôle, les surfaces de la première tôle et/ou de la seconde tôle fournies pour le soudage à froid sont rendues rugueuses, en particulier sont rendues rugueuses par brossage, ou

avant le placement de la seconde tôle entre les deux premières tôles, au moins les surfaces de la première tôle et/ou de la seconde tôle fournies pour le soudage à froid sont rendues rugueuses, en particulier sont rendues rugueuses par brossage.

16. Procédé selon la revendication 15, dans lequel toutes les surfaces de la première tôle ou des deux premières tôles et/ou de la seconde tôle fournies pour le soudage à froid sont rendues rugueuses, de préférence sont redues rugueuses par brossage à l'aide d'une brosse métallique.

Figur 1

Figur 2

Figur 3

Figur 4

Figur 5

Figur 6

| 10 µm | CuNb19  N12  42 µm | Detector = AsB<br>EHT = 20.00 kV<br>WD = 8.2 mm | Heraeus |
|---|---|---|---|

Figur 7

Figur 8

1 µm

CuNb19 N12 42 µm

Detector = AsB
EHT = 20.00 kV
WD = 7.6 mm

Heraeus

Figur 9

200 nm       CuNb19  N12  42 µm      Detector = AsB   EHT = 20.00 kV   WD = 7.6 mm   Heraeus

Figur 10

Figur 11

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 20140266278 A1
- US 20100194415 A1
- WO 2016009293 A1
- US 20130099813 A1
- EP 2060921 A1
- US 20120286816 A1

**In der Beschreibung aufgeführte Nicht-Patentliteratur**

- **T. NIZOLEK ; N.A. MARA ; I.J. BEYERLEIN ; J.T. AVALLONE ; J.E. SCOTT ; T.M. POLLOCK.** Processing and Deformation Behavior of Bulk Cu-Nb Nanolaminates. *Metallogr. Microstruct. Anal.,* 2014, vol. 3, 470-476
- **I.J. BEYERLEIN et al.** Interface-driven microstructure development and ultra high strength of bulk nanostructured Cu-Nb multilayers. *J. Mater. Res.,* 14. Juli 2013, vol. 28 (13
- **J.S. CARPENTER ; R.J. MCCABE ; S.J. ZHENG ; T.A. WYNN ; N.A. MARA ; I.J. BEYERLEIN.** Processing Parameter Influence on Texture and Microstructural Evolution in Cu-Nb Multilayer Composites Fabricated via Accumulative Roll Bonding. *Metallurgical and Materials Transactions A,* April 2014, vol. 45A, 2192-2208
- **S.C. JHA ; R.G. DELAGI ; J.A. FORSTER ; P.D. KROTZ.** High-Strength High-Conductivity Cu-Nb Microcomposite Sheet Fabricated via Multiple Roll Bonding. *Metallurgical and Materials Transactions A,* Januar 1993, vol. 24A, 15-20
- **S.C.V. LIM ; A.D. ROLLETT.** Length sacle effects on recrystallization and texture evolution in Cu layers of a roll-bonded Cu-Nb composite. *Materials Science and Engeneering A,* 2009, vol. 520, 189-195
- **N.A. MARA ; D. BHATTACHARYYA ; R.G. HOAGLAND ; A. MISRA.** Tensile behavior of 40 nm Cu/Nb nanoscale multilayers. *Science Direct, Scripta Materialia,* 2008, vol. 58, 874-877
- **V.I. PANTSYRNY et al.** High-Strength, High-Conductivity Microcomposite Cu-Nb Wires with Cross Sections in the Range of 0.01 - 100 mm. *IEEE Transactions on Applied Superconductivity,* Juni 2008, vol. 18 (2), 616-619
- **W. C. OLIVER ; G. M. PHARR.** *Journal of Materials Research,* 1992
- **J.M. WHEELER et al.** *Curr Opin Solid St M,* 2015, vol. 19, 354-366
- **T. NIZOLEK.** Processing and Deformation Behavior of Bulk Cu-Nb Nanolaminates. *Metallogr. Microstruct. Anal.,* 2014, vol. 3, 470-476